# EUROPÄISCHE PATENTSCHRIFT

(11) **EP 2 733 757 B1**
(45) Veröffentlichungstag und Bekanntmachung des Hinweises auf die Patenterteilung: **12.10.2016**
(21) Anmeldenummer: 13400027.2
(22) Anmeldetag: 19.11.2013
(51) Int. Cl.: H01L 35/32

(54) **Thermoelektrischer Dünnfilm-Generator**
Thermoelectric thin film generator
Générateur thermoélectrique à film mince

(30) Priorität: 20.11.2012 DE 102012022864
(43) Veröffentlichungstag der Anmeldung: 21.05.2014
(73) Patentinhaber: Astrium GmbH, 82024 Taufkirchen (DE)
(72) Erfinder: Sebald, Johannes, 27721 Ritterhude (DE); Kesuma, Hendra, 28277 Bremen (DE)
(74) Vertreter: Marschall, Stefan

(56) Entgegenhaltungen:
- EP-A2- 1 976 034
- JP-A- 2004 241 657
- US-A- 3 053 923
- US-A1- 2006 151 021
- US-A1- 2008 173 537
- Azat Ibragimov ET AL: "MICROMACHINED THERMOGENERATOR FOR HIGH-TEMPERATURE APPLICATIONS", Proceedings of PowerMEMS 2011, 15. November 2011 (2011-11-15), Seiten 298-301, XP055116205, Seoul, Korea Gefunden im Internet: URL:http://cap.ee.imperial.ac.uk/~pdm97/po wermems/2011/Poster/P-25.pdf [gefunden am 2014-05-02]
- AZAT IBRAGIMOV ET AL: "A Thermoelectric Energy Harvester Directly Embedded Into Casted Aluminum", IEEE ELECTRON DEVICE LETTERS, IEEE SERVICE CENTER, NEW YORK, NY, US, Bd. 33, Nr. 2, 1. Februar 2012 (2012-02-01), Seiten 233-235, XP011393520, ISSN: 0741-3106, DOI: 10.1109/LED.2011.2174605

## Beschreibung

Die Erfindung betrifft einen thermoelektrischen Dünnfilm-Generator insbesondere für einen Einsatz unter Weltraumbedingungen.

Bei thermoelektrischen Dünnfilm-Generatoren wird die aufgenommene Wärme direkt in Elektrizität umwandelt. Geräte dieser Art sind beispielsweise in dem Artikel "Small Thermoelectric Generators" von G. J. Snyder in der Herbstausgabe 2008 der Zeitschrift "The Electrochemical Society Interface", Seiten 54 bis 56, beschrieben. So ist ein thermoelektrischer Dünnfilm-Generator dieser Art bekannt geworden, bei dem ein sehr dünnes thermoelektrisches Material mit einer Dicke zwischen 5 und 15 Mikrometern verwendet wird und das außergewöhnlich hohe Wärmeströme und niedrige thermische Widerstände ermöglicht, so daß sich als ein Ergebnis eine viel höhere Leistungsdichte als mit herkömmlichen thermoelektrischen Modulen erreichen läßt.

Ein großer Vorteil derartiger thermoelektrischer Dünnfilm-Generatoren liegt darin, daß sie mit einer nur geringen Temperaturdifferenz betrieben werden können. Andererseits besteht ein Problem dadurch, daß ein thermoelektrischer Generator bei Temperaturen oberhalb von 700°C unter Umständen zerstört werden kann.

EP 1 976 034 A1 zeigt einen thermoelektrischen Generator, dessen Generatorelemente auf einer Membran angeordnet sind. Die Membran bildet ein Substrat für die Generatorelemente.

2008 / 173537 A1 zeigt einen thermoelektrischen Generator, dessen Generatorelemente ebenfalls auf einem Substrat angeordnet und über dieses miteinander verbunden sind.

JP2004241657 A zeigt ebenfalls einen thermoelektrischen Generator, dessen Generatoreiemente auf einem Substrat angeordnet und über dieses miteinander verbunden sind.

Aufgabe der Erfindung ist es, einen hochtemperaturfähigen thermoelektrischen Dünnfilm-Generator bereitzustellen.

Die Erfindung löst diese Aufgabe dadurch, daß der Generator als Dünnfilm-Generator aufgebaut ist und dass zwischen der heißen Seite und der kalten Seite des Generators eine Reihe von thermoelektrischen Dünnfilm-Generatorelementen angeordnet ist, die thermisch voneinander durch ein Vakuum und gegenüber der heißen Seite und der kalten Seite thermisch durch ein Wärmeisolierungsmaterial isoliert sind.

Die Vorteile des erfindungsgemäßen Generators liegen zum einen darin, daß das Material der heißen Seite die Elemente des thermoelektrischen Dünnfilm-Generators vor direkter Hitzeeinwirkung schützt. Zum anderen erhöht die Kombination des Wärmeisolierungsmaterials mit den evakuierten Bereichen signifikant den Wirkungsgrad des thermoelektrischen Dünnfilm-Generators, da einem thermischen Kurzschluß entgegen gewirkt wird. Schließlich ergibt sich durch den Aufbau des thermoelektrischen Dünnfilm-Generators nach der Erfindung eine geringere Dicke der verwendeten Module, die sie insbesondere für einen Einsatz bei Weltraummissionen besonders geeignet macht.

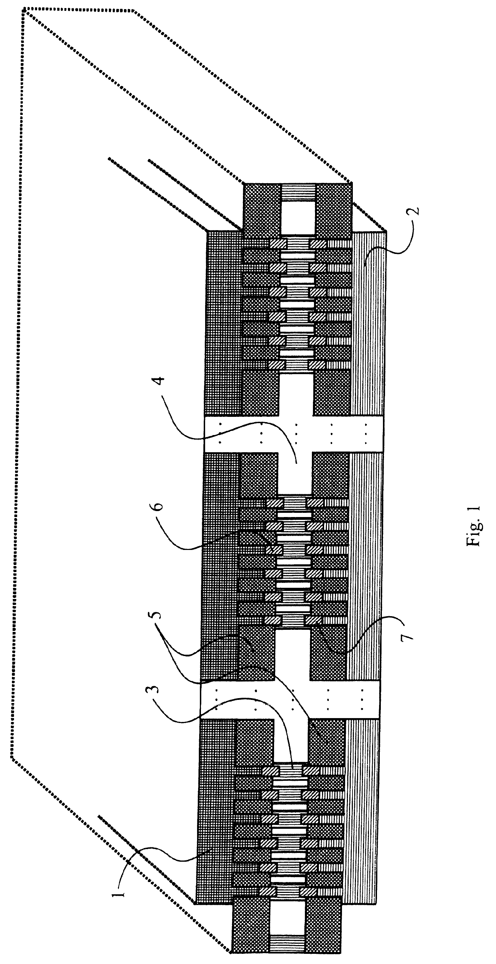

Nachfolgend soll die Erfindung anhand eines in der Zeichnung dargestellten Ausführungsbeispiels näher erläutert werden.

Die Abbildung zeigt ein hochtemperaturfähigen, leichtgewichtigen thermoelektrischen Dünnfilm-Generatormodul, das insbesondere für einen Einsatz bei Weltraummissionen geeignet ist, mit einer heißen Seite 1, einer kalten Seite 2 und einer Reihe von kleineren thermoelektrischen Dünnfilm-Generatorelementen 3. Letztere sind zwischen den beiden Seiten 1 und 2 angeordnet und durch ein Vakuum 4 voneinander und durch ein Wärmeisolierungsmaterial 5 gegenüber der heißen Seite 1 und der kalten Seite 2 thermisch isoliert. Der Aufbau dieser kleineren thermoelektrischen Dünnfilm-Generatorelemente ist bekannt und beispielsweise in der Veröffentlichung "Micromashined Thermogenerator for High-Temperature Applications" von A. Ibragimov und W. Lang, Seiten 298 bis 301, in den Proceedings Power MEMS, 2011, erschienen im Internet unter http://cap.ee.ic.ac.uk/-pdm97/powermems/2011/, beschrieben und soll deshalb hier nicht näher erläutert werden.

Schließlich sind an den Dünnfilm-Generatorelementen 3 auf der heißen Seite 1 Kontakte 6 und auf der kalten Seite 2 Kontakte 7 angeordnet.

Die Wärme fließt vom Material der heißen Seite zu den Kontakten 6, dann zu den Dünnfilm-Generatorelementen 3 und anschließend zu den auf der gegenüber Seite angeordneten Kontakten 7. Das Material des in der Figur dargestellten thermoelektrischen Dünnfilm-Generatormoduls ist auf der heißen Seite 1 für Temperaturen oberhalb der Arbeitstemperatur des Generators ausgelegt, im vorliegenden Fall besteht es aus Silizium, Wolfram, Titan und Platin. Das Wärmeisolierungsmaterial 5, im vorliegenden Fall Borosilikatglas, und das Vakuum 4 zwischen der heißen Seite 1 und der kalten Seite 2 des Moduls wirken dabei einem thermischen Kurzschluß entgegen. Schließlich ist anzumerken, daß das in der Figur dargestellte thermoelektrische Dünnfilm-Generatormodul in eine Reihe von Partitionen, im Fall des hier dargestellten Ausführungsbeispiels drei Partitionen, unterteilt ist.

## Patentansprüche

1. Thermoelektrischer Generator insbesondere für einen Einsatz unter Weltraumbedingungen, wobei der Generator als Dünnfilm-Generator aufgebaut ist und dass zwischen der heißen Seite (2) und der kalten Seite (1) des Generators eine Reihe von thermoelektrischen DünnfilmGeneratorelementen (3) angeordnet ist, **dadurch gekennzeichnet, dass** die Reihe von thermoelektrischen Dünnfilm-Generatorelementen thermisch voneinander durch ein Vakuum (4) und gegenüber der heißen Seite (2) und der kalten Seite (1) thermisch durch ein Wärmeisolierungsmaterial (5) isoliert sind.

2. Thermoelektrischer Generator nach Anspruch 1, **dadurch gekennzeichnet, dass** das Wärmeisolierungsmaterial (5) aus Borosilikatglas besteht.

3. Thermoelektrischer Generator nach einem der Ansprüche 1 oder 2, **dadurch gekennzeichnet, dass** das Material des thermoelektrischen Generatormoduls aus Silizium besteht.

## Claims

1. A thermoelectric generator, in particular for use under space conditions, the generator being constructed as a thin-film generator and a series of thermoelectric thin-film generator elements (3) being arranged between the hot side (2) and the cold side (1) of the generator, **characterised in that** the series of thermoelectric thin-film generator elements are thermally insulated from each other by a vacuum (4) and are thermally insulated from the hot side (2) and the cold side (1) by means of a thermal insulation material (5).

2. The thermoelectric generator according to claim 1, **characterised in that** the thermal insulation material (5) consists of borosilicate glass.

3. The thermoelectric generator according to any one of claims 1 or 2, **characterised in that** the material of the thermoelectric generator module consists of silicon.

## Revendications

1. Générateur thermoélectrique, en particulier pour une utilisation dans des conditions spatiales, le générateur étant configuré comme générateur à couche mince et une série d'éléments thermoélectriques de générateur à couche mince (3) étant disposée entre le côté chaud (2) et le côté froid (1) du générateur, **caractérisé en ce que** les éléments thermoélectriques de générateur à couche mince de la série sont thermiquement isolés les uns des autres par un vide (4) et thermiquement isolés par rapport au côté chaud (2) et au côté froid (1) par un matériau thermo-isolant (5).

2. Générateur thermoélectrique selon la revendication 1, **caractérisé en ce que** le matériau thermo-isolant (5) est composé de verre au borosilicate.

3. Générateur thermoélectrique selon l'une quelconque des revendications 1 ou 2, **caractérisé en ce que** le matériau du module thermoélectrique de générateur est composé de silicium.
